# EUROPEAN PATENT APPLICATION

(11) **EP 4 645 363 A1**
(43) Date of publication of application: **05.11.2025**
(21) Application number: 23910462.3
(22) Date of filing: 25.12.2023
(51) Int. Cl.: H01J 37/317, H01J 37/32

(54) **ION BEAM ETCHING UNIFORMITY ADJUSTMENT APPARATUS AND METHOD**

(30) Priority: 30.12.2022 CN 202211727242
(71) Applicant: Jiangsu Leuven Instruments Co. Ltd, Xuzhou, Jiangsu 221300 (CN)
(72) Inventor: WANG, Xiang, Xuzhou, Jiangsu 221300 (CN); LIU, Xiaobo, Xuzhou, Jiangsu 221300 (CN); WANG, Zhichao, Xuzhou, Jiangsu 221300 (CN); CHAO, Jiefang, Xuzhou, Jiangsu 221300 (CN); DOU, Yang, Xuzhou, Jiangsu 221300 (CN); HU, Dongdong, Xuzhou, Jiangsu 221300 (CN); CHEN, Lu, Xuzhou, Jiangsu 221300 (CN); XU, Kaidong, Xuzhou, Jiangsu 221300 (CN)
(74) Representative: Eisenführ Speiser
(86) International application number: PCT/CN2023/141456
(87) International publication number: WO 2024/140536

(57) **Abstract**

The present invention provides an ion beam etching uniformity adjustment apparatus and method. A uniformity adjustment capacitor component and a uniformity adjustment coil assembly which is installed at a preset position of a discharging cavity achieve adjustment of the power of a planar coil and/or cylindrical coil in the uniformity adjustment coil assembly, finally achieving adjustment of a plasma density distribution in the discharging cavity; moreover, the arrangement of the planar coil and/or cylindrical coil at the installation position can be further optimized (for instance, giving the planar coil and/or cylindrical coil a non-centrally-symmetrical arrangement or a centrally-symmetrical arrangement), and the plasma density distribution in the discharge cavity can additionally be further precisely optimized and adjusted, so as to achieve an expected plasma density distribution in the discharge cavity, and thereby achieve ion beam etching uniformity adjustment.

## Description

This application claims priority of Chinese Patent Application No. 202211727242.1, titled "ION BEAM ETCHING UNIFORMITY ADJUSTMENT APPARATUS AND METHOD", filed with the China National Intellectual Property Administration on December 30, 2022, which is incorporated herein by reference in its entirety.

### FIELD

The present disclosure relates to the technical field of semiconductor processes, and in particular to an apparatus and method for uniformity adjustment in ion beam etching.

### BACKGROUND

A grating plate is a precision optical element with a spatially periodic structure. The grating plate enables customizable coloration and is odorless, tasteless, and non-toxic while maintaining rigidity, electrical insulation, and exceptional printability. By exploiting the principle of light diffraction, the grating plate decomposes polychromatic light to achieve transformation of phase and amplitude of light interacting with an object. A human brain synthesizes views from multiple angular perspectives acquired by eyes through binocular disparity, creating stereoscopic images. A grating plate is widely adopted in indoor advertising light boxes for guesthouses, hotels, shopping malls, gyms, airport terminals, waiting halls and the like, wedding photography studios, portraits and decorative paintings.

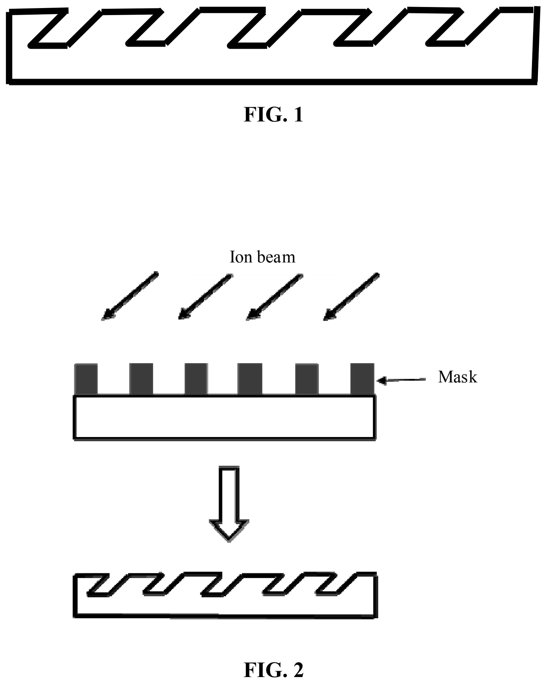

In the conventional technology, during the fabrication of integrated circuit chips, a symmetrical toothed grating plate, such as a right-angled type, a chamfered type, or a bevelled type of the plate, is fabricated by exposing a photoresist through photolithography and subsequently removing unnecessary portions through etching. However, the three-dimensional imaging performance of the symmetrical grating plate is poor. To improve the three-dimensional imaging performance, a slanted grating is developed. A structure of the slanted grating is shown in FIG. 1 which is a schematic structural diagram of a slanted grating.

Furthermore, reference is made to FIG. 2, which is a schematic diagram of an etching process of the slanted grating shown in FIG. 1. The slanted grating is typically fabricated through reactive ion beam etching based on a mask. Specifically, a reactive gas such as CHF₃ or CHF₄ is introduced into a discharge chamber. The reactive gas is ionized to generate plasma. The plasma is extracted through an optical grid to form an ion beam with a direction and energy. The ion beam is capable of both physical bombardment and chemical reaction. On one hand, a directional movement of ions and a physical sputtering effect ensure a high resolution and anisotropy of an etched pattern. On the other hand, a chemical reaction of the ions provides a high selectivity ratio.

A mask is prepared on the surface of a material in advance, forming local open and closed regions for the ion beam. If the ion beam is perpendicular to a grating substrate, a cross section of an etched grating is rectangular or trapezoidal. If the ion beam intersects with the grating substrate obliquely, a slanted grating shown in FIG. 2 is etched.

However, during a fabrication process of the slanted grating, it is required to maintain an angle between the ion beam and the grating substrate, and the stage for carrying the grating substrate is not capable of self-rotation. This leads to etching in regions close to the ion beam faster than etching in regions away from the ion beam, resulting in a banded distribution. Thus, controlling etching uniformity is critical, particularly when an area of the grating substrate to be etched is large.

Therefore, how to adjust the uniformity of ion beam etching is a technical problem to be addressed by those skilled in the art.

### SUMMARY

In view of this, an apparatus and a method for uniformity adjustment in ion beam etching are provided according to the present disclosure, to solve the above problem. Technical solutions are described as follows.

A uniformity adjustment apparatus for ion beam etching is provided. The uniformity adjustment apparatus includes a radio frequency power supply, a power supply matching network, a uniformity adjustment capacitor component, a uniformity adjustment coil component and a discharge chamber. The uniformity adjustment coil component includes a surface coil and a cylindrical coil. A first terminal of the cylindrical coil is connected to a first output terminal of the uniformity adjustment capacitor component, and a first terminal of the surface coil is connected to a second output terminal of the uniformity adjustment capacitor component. The surface coil is arranged at a bottom of the discharge chamber and the cylindrical coil is wound on an outer sidewall of the discharge chamber.

The radio frequency power supply is configured to generate a first operating voltage for controlling generation of plasma in the discharge chamber.

The power supply matching network is configured to adjust an output of the radio frequency power supply.

The uniformity adjustment capacitor component is configured to adjust a power of the surface coil and/or a power of the cylindrical coil through adjusting a capacitance of the uniformity adjustment capacitor component, to adjust a plasma density distribution in the discharge chamber.

In an embodiment, in the above-described uniformity adjustment apparatus, the power supply matching network includes a first adjustable capacitor, a first induction coil and a first capacitor.

A first terminal of the first induction coil is connected to a first terminal of the first adjustable capacitor at a connection node, and the connection node is connected to an output terminal of the radio frequency power supply.

A second terminal of the first adjustable capacitor is grounded.

A second terminal of the first induction coil is connected to a first terminal of the first capacitor, and a second terminal of the first capacitor is configured as an output terminal of the power supply matching network.

In an embodiment, in the above-described uniformity adjustment apparatus, the uniformity adjustment capacitor component includes a second adjustable capacitor and a third adjustable capacitor.

A first terminal of the second adjustable capacitor is connected to a first terminal of the third adjustable capacitor at a connection node, and the connection node is connected to an output terminal of the power supply matching network.

A second terminal of the second adjustable capacitor is configured as a first output terminal of the uniformity adjustment capacitor component.

A second terminal of the third adjustable capacitor is configured as a second output terminal of the uniformity adjustment capacitor component.

In an embodiment, in the above-described uniformity adjustment apparatus, a capacitance of the second adjustable capacitor ranges from OpF to 250pF.

In an embodiment, in the above-described uniformity adjustment apparatus, a capacitance of the third adjustable capacitor ranges from OpF to 250pF.

In an embodiment, the above-described uniformity adjustment apparatus further includes a second capacitor and a third capacitor.

A second terminal of the surface coil is grounded through the second capacitor.

A second terminal of the cylindrical coil is grounded through the third capacitor.

In an embodiment, in the above-described uniformity adjustment apparatus, the surface coil is arranged in a non-centrosymmetric manner at the bottom of the discharge chamber.

In an embodiment, in the above-described uniformity adjustment apparatus, the surface coil is arranged in a centrosymmetric manner at the bottom of the discharge chamber.

In an embodiment, in the above-described uniformity adjustment apparatus, the cylindrical coil is arranged in a non-centrosymmetric manner on the outer sidewall of the discharge chamber.

In an embodiment, in the above-described uniformity adjustment apparatus, the cylindrical coil is arranged in a centrosymmetric manner on the outer sidewall of the discharge chamber.

In an embodiment, the above-described uniformity adjustment apparatus further includes an optical grid system.

The optical grid system is configured to extract the plasma generated in the discharge chamber.

In an embodiment, in the above-described uniformity adjustment apparatus, the optical grid system includes a grid.

The grid is arranged at an outlet of the discharge chamber, the grid includes a screen grid and an acceleration grid, and the screen grid is arranged between the acceleration grid and the outlet of the discharge chamber.

In an embodiment, in the above-described uniformity adjustment apparatus, the optical grid system further includes a first power supply and a second power supply.

The first power supply is connected to the screen grid.

The second power supply is connected to the acceleration grid.

In an embodiment, in the above-described uniformity adjustment apparatus, the optical grid system further includes a first filter and a second filter.

The first power supply is connected to the screen grid through the first filter.

The second power supply is connected to the acceleration grid through the second filter.

In an embodiment, in the above-described uniformity adjustment apparatus, the first filter includes a fourth capacitor and a second induction coil.

A first terminal of the fourth capacitor is connected to a first terminal of the second induction coil at a connection node, and the connection node is connected to an output terminal of the first power supply.

A second terminal of the second induction coil is connected to the screen grid.

A second terminal of the fourth capacitor is grounded.

In an embodiment, in the above-described uniformity adjustment apparatus, the second filter includes a fifth capacitor and a third induction coil.

A first terminal of the fifth capacitor is connected to a first terminal of the third induction coil at a connection node, and the connection node is connected to an output terminal of the second power supply.

A second terminal of the third induction coil is connected to the acceleration grid.

A second terminal of the fifth capacitor is grounded.

A uniformity adjustment method for ion beam etching is provided. Based on the uniformity adjustment apparatus described in any one of the above embodiments, the uniformity adjustment method includes:
controlling the radio frequency power supply to generate the first operating voltage, where the first operating voltage is configured to control the generation of plasma in the discharge chamber;
controlling the power supply matching network to adjust the output of the radio frequency power supply; and
adjusting the capacitance of the uniformity adjustment capacitor component to adjust the power of the surface coil and/or the power of the cylindrical coil, to adjust the plasma density distribution in the discharge chamber.

In an embodiment, in the above-described uniformity adjustment method, the uniformity adjustment capacitor component includes a second adjustable capacitor and a third adjustable capacitor.

A first terminal of the second adjustable capacitor is connected to a first terminal of the third adjustable capacitor at a connection node, and the connection node is connected to an output terminal of the power supply matching network; a second terminal of the second adjustable capacitor is configured as a first output terminal of the uniformity adjustment capacitor component; and a second terminal of the third adjustable capacitor is configured as a second output terminal of the uniformity adjustment capacitor component.

The adjusting the capacitance of the uniformity adjustment capacitor component to adjust the power of the surface coil and/or the power of the cylindrical coil, to adjust the plasma density distribution in the discharge chamber include: adjusting a capacitance of the second adjustable capacitor and/or a capacitance of the third adjustable capacitor to adjust the power of the surface coil and/or the power of the cylindrical coil, to adjust the plasma density distribution in the discharge chamber.

In an embodiment, in the above-described uniformity adjustment method, the capacitance of the second adjustable capacitor ranges from OpF to 250pF.

In an embodiment, in the above-described uniformity adjustment method, the capacitance of the third adjustable capacitor ranges from OpF to 250pF.

Compared to the conventional technology, the present disclosure can achieve the following beneficial effects.

A uniformity adjustment apparatus for ion beam etching according to the present disclosure includes a radio frequency power supply, a power supply matching network, a uniformity adjustment capacitor component, a uniformity adjustment coil component and a discharge chamber. The uniformity adjustment coil component includes a surface coil and a cylindrical coil. A first terminal of the cylindrical coil is connected to a first output terminal of the uniformity adjustment capacitor component, and a first terminal of the surface coil is connected to a second output terminal of the uniformity adjustment capacitor component. The surface coil is arranged at a bottom of the discharge chamber and the cylindrical coil is wound on an outer sidewall of the discharge chamber. The radio frequency power supply is configured to generate a first operating voltage for controlling generation of plasma in the discharge chamber. The power supply matching network is configured to adjust an output of the radio frequency power supply. The uniformity adjustment capacitor component is configured to adjust a power of the surface coil and/or a power of the cylindrical coil through adjusting a capacitance of the uniformity adjustment capacitor component, to adjust a plasma density distribution in the discharge chamber.

In the uniformity adjustment apparatus for ion beam etching, the power of the surface coil and/or the power of the cylindrical coil in the uniformity adjustment coil component arranged at a pre-determined position of the discharge chamber is adjusted through the uniformity adjustment capacitor component, so as to adjust the plasma density distribution in the discharge chamber. In addition, the configurations of the arrangement of the surface coil and/or the cylindrical coil may be further optimized (for example, the surface coil and/or the cylindrical coil is arranged in a non-centrosymmetric manner or a centrosymmetric manner) to further precisely adjust the plasma density distribution in the discharge chamber, so that a desired plasma density distribution in the discharge chamber is achieved, thereby realizing uniformity adjustment in ion beam etching, especially in etching of a slanted grating.

### BRIEF DESCRIPTION OF THE DRAWINGS

In order to more clearly describe the technical solutions in the embodiments of the present disclosure or the conventional technology, drawings to be used in the description of the embodiments or the conventional technology are briefly described hereinafter. It is apparent that the drawings described hereinafter are merely used for illustrating the embodiments of the present disclosure, and those skilled in the art can obtain other drawings according to the drawings without any creative effort.
FIG. 1 is a schematic structural diagram of a slanted grating;
FIG. 2 is a schematic diagram of an etching process of the slanted grating shown in FIG. 1;
FIG. 3 is a schematic structural diagram illustrating a principle of a uniformity adjustment apparatus for ion beam etching according to an embodiment of the present disclosure;
FIG. 4 is a schematic structural diagram of a cylindrical coil according to an embodiment of the present disclosure;
FIG. 5 is a schematic structural diagram of a surface coil according to an embodiment of the present disclosure;
FIG. 6 is a schematic diagram of an arrangement of a surface coil and a cylindrical coil on a discharge chamber according to an embodiment of the present disclosure;
FIG. 7 is a schematic diagram of an arrangement of a surface coil and a cylindrical coil according to another embodiment of the present disclosure;
FIG. 8 is a schematic diagram of an arrangement of a surface coil and a cylindrical coil according to another embodiment of the present disclosure;
FIG. 9 is a schematic diagram of an arrangement of a surface coil and a cylindrical coil according to another embodiment of the present disclosure;
FIG. 10 is a schematic diagram of an arrangement of a surface coil and a cylindrical coil according to another embodiment of the present disclosure; and
FIG. 11 is a flowchart of a process of a uniformity adjustment method for ion beam etching according to an embodiment of the present disclosure.

### DETAILED DESCRIPTION

Technical solutions of embodiments of the present disclosure are clearly and completely described hereinafter in conjunction with the drawings of the embodiments of the present disclosure. Apparently, the embodiments described are only some embodiments of the present disclosure, rather than all embodiments. Any other embodiments obtained by those skilled in the art based on the embodiments in the present disclosure without any creative work fall within the protection scope of the present disclosure.

Based on the content described in background, an apparatus and a method for uniformity adjustment in ion beam etching are provided according to embodiments of the present disclosure. A power of a surface coil and/or a power of a cylindrical coil in a uniformity adjustment coil component arranged at a pre-determined position of a discharge chamber is regulated through a uniformity adjustment capacitor component, achieving adjustment of a plasma density distribution in the discharge chamber. In addition, configurations of the arrangement of the surface coil and/or the cylindrical coil may be further optimized (for example, the surface coil and/or the cylindrical coil is arranged in a non-centrosymmetric manner or a centrosymmetric manner) to further precisely adjust the plasma density distribution in the discharge chamber, so that a desired plasma density distribution in the discharge chamber is achieved. The plasma is then extracted from the optical grid system, thereby realizing uniformity adjustment in ion beam etching, especially in etching of a slanted grating.

The present disclosure is illustrated in detail in conjunction with the drawings and specific embodiments hereinafter, so that the above purposes, features and advantages of the present disclosure are understandable.

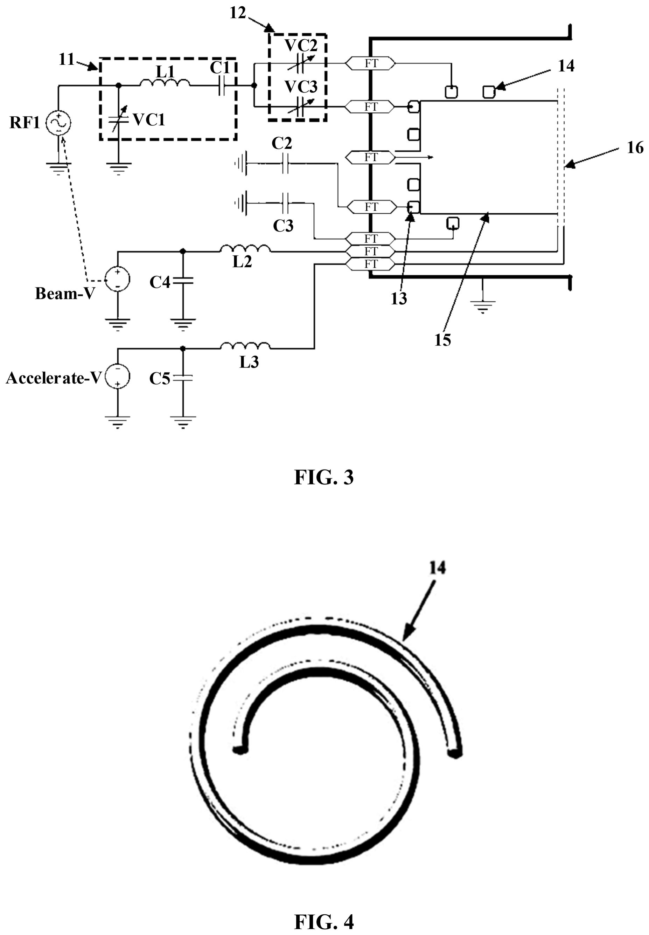

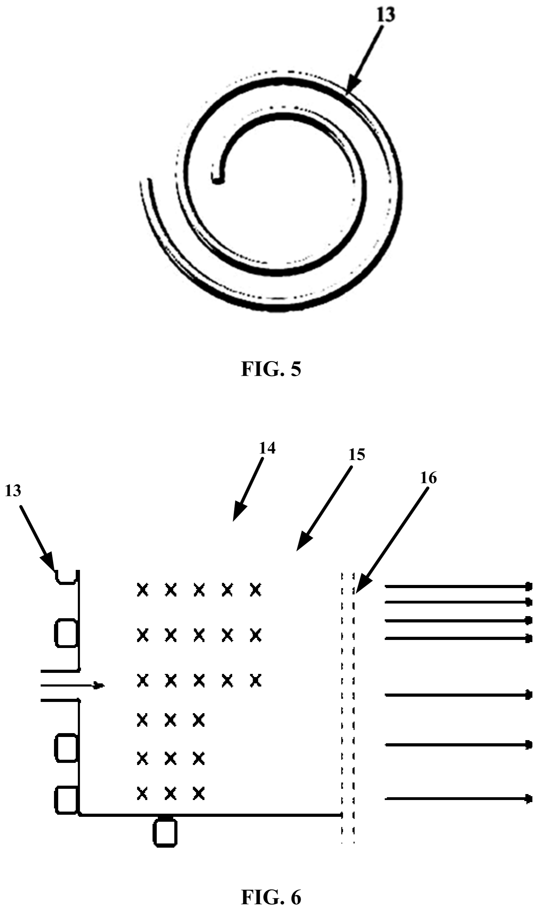

Reference is made to FIG. 3, which is a schematic structural diagram illustrating a principle of a uniformity adjustment apparatus for ion beam etching according to an embodiment of the present disclosure. Reference is made to FIG. 4, which is a schematic structural diagram of a cylindrical coil according to an embodiment of the present disclosure. Reference is made to FIG. 5, which is a schematic structural diagram of a surface coil according to an embodiment of the present disclosure. The uniformity adjustment apparatus for ion beam etching includes a radio frequency power supply RF1, a power supply matching network 11, a uniformity adjustment capacitor component 12, a uniformity adjustment coil component and a discharge chamber 15. The uniformity adjustment coil component includes a surface coil 13 and a cylindrical coil 14. A first terminal of the cylindrical coil 14 is connected to a first output terminal of the uniformity adjustment capacitor component 12. A first terminal of the surface coil 13 is connected to a second output terminal of the uniformity adjustment capacitor component 12. The surface coil 13 is arranged at the bottom of the discharge chamber 15 and the cylindrical coil 14 is wound on an outer sidewall of the discharge chamber 15.

The radio frequency power supply RF1 is configured to generate a first operating voltage for controlling generation of plasma in the discharge chamber 15.

The power supply matching network 11 is configured to adjust an output of the radio frequency power supply RF1.

The uniformity adjustment capacitor component 12 is configured to adjust a power of the surface coil and/or a power of the cylindrical coil through adjusting a capacitance of the uniformity adjustment capacitor component, to adjust a plasma density distribution in the discharge chamber 15.

In an embodiment of the present disclosure, the radio frequency power supply RF1, the power supply matching network 11, the uniformity adjustment capacitor component 12, the uniformity adjustment coil component, and the discharge chamber 15 function as a whole configured to excite ionization in the discharge chamber 15 to generate plasma.

In the uniformity adjustment apparatus for ion beam etching, the power of the surface coil 13 and/or the power of the cylindrical coil 14 in the uniformity adjustment coil component arranged at a pre-determined position of the discharge chamber 15 is adjusted through the uniformity adjustment capacitor component 12, so as to adjust the plasma density distribution in the discharge chamber 15. In addition, the configurations of the arrangement of the surface coil 13 and/or the cylindrical coil 14 may be further optimized (for example, the surface coil 13 and/or the cylindrical coil 14 is arranged in a non-centrosymmetric manner or a centrosymmetric manner) to further precisely adjust the plasma density distribution in the discharge chamber 15, so that a desired plasma density distribution in the discharge chamber 15 is achieved, thereby realizing uniformity adjustment in ion beam etching, especially in etching of a slanted grating.

In another embodiment of the present disclosure, as shown in FIG. 3, the power supply matching network 11 includes a first adjustable capacitor VC1, a first induction coil L1, and a first capacitor C1.

A first terminal of the first induction coil L1 is connected to a first terminal of the first adjustable capacitor VC1 at a connection node, and the connection node is connected to an output terminal of the radio frequency power supply RF 1.

A second terminal of the first adjustable capacitor VC1 is grounded.

A second terminal of the first induction coil L1 is connected to a first terminal of the first capacitor C1, and a second terminal of the first capacitor C1 is configured as an output terminal of the power supply matching network 11.

In an embodiment of present disclosure, the first adjustable capacitor VC1 may be implemented by a capacitor with an adjustable capacitance, such as a motor capacitor. The capacitance and inductance of the power supply matching network 11 is adjusted to ensure a matched operating state of the radio frequency power supply RF 1.

In another embodiment of the present disclosure, as shown in FIG. 3, the uniformity adjustment capacitor component 12 includes a second adjustable capacitor VC2 and a third adjustable capacitor VC3.

A first terminal of the second adjustable capacitor VC2 is connected to a first terminal of the third adjustable capacitor VC3 at a connection node, and the connection node is connected to the output terminal of the power supply matching network 11.

A second terminal of the second adjustable capacitor VC2 is configured as a first output terminal of the uniformity adjustment capacitor component 12.

A second terminal of the third adjustable capacitor VC3 is configured as a second output terminal of the uniformity adjustment capacitor component 12.

In an embodiment, a capacitance of the second adjustable capacitor VC2 ranges from OpF to 250pF.

A capacitance of the third adjustable capacitor VC3 ranges from OpF to 250pF.

In an embodiment, as shown in FIG. 3, the uniformity adjustment apparatus further includes a second capacitor C2 and a third capacitor C3.

A second terminal of the surface coil 13 is grounded through the second capacitor C2.

A second terminal of the cylindrical coil 14 is grounded through the third capacitor C3.

In an embodiment of the present disclosure, the second adjustable capacitor VC2 may be implemented by a capacitor with an adjustable capacitance, such as a motor capacitor. Similarly, the third adjustable capacitor VC3 may be implemented by a capacitor with an adjustable capacitance, such as a motor capacitor. Since a radio frequency power outputted through the power supply matching network 11 is constant, an impedance of a branch where the second adjustable capacitor VC2 is arranged and/or an impedance of a branch where the third adjustable capacitor VC3 is arranged may be adjusted through adjusting a capacitance of the second adjustable capacitor VC2 and/or a capacitance of the third adjustable capacitor VC3, implementing adjustment of a power of the surface coil 13 and/or a power of the cylindrical coil 14 in the uniformity adjustment coil component. Thus, plasma density distribution in the discharge chamber 15 is adjusted.

In another embodiment of the present disclosure, the surface coil 13 is arranged in a non-centrosymmetric manner at the bottom of the discharge chamber 15, or the surface coil 13 is arranged in a centrosymmetric manner at the bottom of the discharge chamber 15.

The cylindrical coil 14 is arranged in a non-centrosymmetric manner on an outer sidewall of the discharge chamber 15, or the cylindrical coil 14 is arranged in a centrosymmetric manner on the outer sidewall of the discharge chamber 15.

In an embodiment of the present disclosure, the surface coil 13 and the cylindrical coil 14 may be arranged as the following four combinations. For a first combination, the surface coil 13 is arranged in a non-centrosymmetric manner at the bottom of the discharge chamber 15, and the cylindrical coil 14 is arranged in a non-centrosymmetric manner on the outer sidewall of the discharge chamber 15. For a second combination, the surface coil 13 is arranged in a non-centrosymmetric manner at the bottom of the discharge chamber 15, and the cylindrical coil 14 is arranged in a centrosymmetric manner on the outer sidewall of the discharge chamber 15. For a third combination, the surface coil 13 is arranged in a centrosymmetric manner at the bottom of the discharge chamber 15, and the cylindrical coil 14 is arranged in a non-centrosymmetric manner on the outer sidewall of the discharge chamber 15. For a fourth combination, the surface coil 13 is arranged in a centrosymmetric manner at the bottom of the discharge chamber 15, and the cylindrical coil 14 is arranged in a centrosymmetric manner on the outer sidewall of the discharge chamber 15. A combination may be selected according to actual requirements and is not limited in the embodiments of the present disclosure.

In an embodiment of the present disclosure, based on different arrangement combinations of the surface coil 13 and the cylindrical coil 14, a desired plasma density distribution can be achieved, thereby achieving the uniformity adjustment in etching.

Descriptions of arrangement combination configurations of the surface coil 13 and the cylindrical coil 14 are provided below in detail.

According to a first configuration, reference is made to FIG. 6, which is a schematic diagram of an arrangement of a surface coil and a cylindrical coil on a discharge chamber according to an embodiment of the present disclosure. As shown in FIG. 6, the cylindrical coil 14 is wound on the outer sidewall of the discharge chamber 15 in a non-centrosymmetric manner, and the surface coil 13 is arranged in a centrosymmetric manner at the bottom of the discharge chamber 15. The radio frequency coil on the upper part of the discharge chamber 15 is one half-turn more than the lower part, resulting in a stronger induced electric field in the upper part than in the lower part. In this way, a non-uniform distribution of plasma with more plasma in the upper part and less in the lower part of the discharge chamber 15 is achieved. In addition, through adjusting a capacitance of the second adjustable capacitor VC2 and a capacitance of the third adjustable capacitor VC3, a power distribution between the surface coil 13 and the cylindrical coil 14 is adjusted, achieving refined uniformity adjustment.

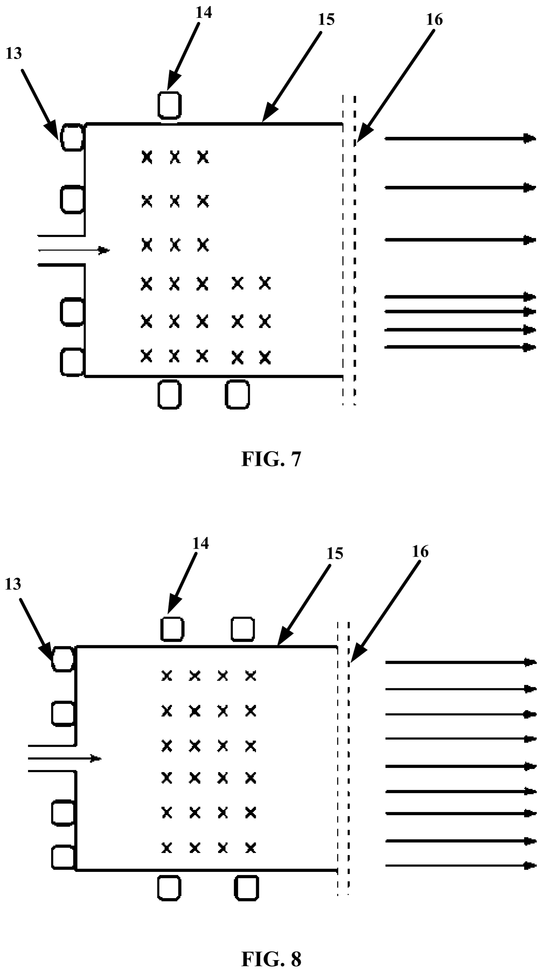

According to a second configuration, reference is made to FIG. 7, which is a schematic diagram of an arrangement of a surface coil and a cylindrical coil on a discharge chamber according to another embodiment of the present disclosure. As shown in FIG. 7, the cylindrical coil 14 is wound on the outer sidewall of the discharge chamber 15 in a non-centrosymmetric manner, and the surface coil 13 is arranged in a centrosymmetric manner at the bottom of the discharge chamber 15. The radio frequency coil on the upper part of the discharge chamber 15 is one half-turn fewer than the lower part, resulting in a weaker induced electric field in the upper part than in the lower part. In this way, a non-uniform distribution of plasma with less plasma in the upper part and more in the lower part of the discharge chamber 15 is achieved. In addition, through adjusting the capacitance of the second adjustable capacitor VC2 and the capacitance of the third adjustable capacitor VC3, the power distribution between the surface coil 13 and the cylindrical coil 14 is adjusted, achieving refined uniformity adjustment.

According to a third configuration, reference is made to FIG. 8, which is a schematic diagram of an arrangement of a surface coil and a cylindrical coil on a discharge chamber according to another embodiment of the present disclosure. As shown in FIG. 8, the cylindrical coil 14 is wound on the outer sidewall of the discharge chamber 15 a centrosymmetric manner, and the surface coil 13 is arranged in a centrosymmetric manner at the bottom of the discharge chamber 15, achieving a uniform distribution of plasma between the upper part and the lower part of the discharge chamber 15. In addition, through adjusting the capacitance of the second adjustable capacitor VC2 and the capacitance of the third adjustable capacitor VC3, the power distribution between the surface coil 13 and the cylindrical coil 14 is adjusted, achieving refined uniformity adjustment.

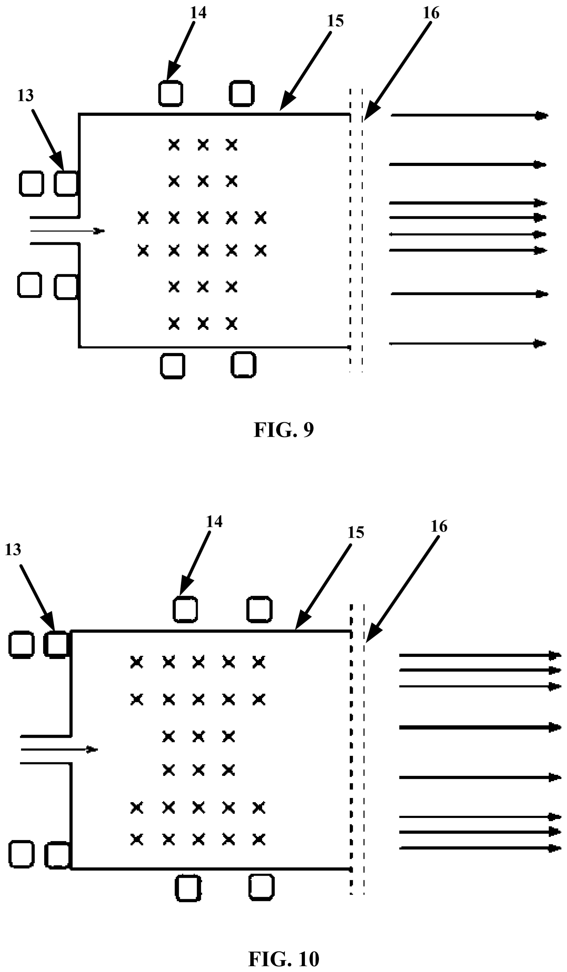

According to a fourth configuration, reference is made to FIG. 9, which is a schematic diagram of an arrangement of a surface coil and a cylindrical coil on a discharge chamber according to another embodiment of the present disclosure. As shown in FIG. 9, the cylindrical coil 14 is wound on the outer sidewall of the discharge chamber 15 a centrosymmetric manner, and the surface coil 13 is arranged in a centrosymmetric manner in a central region of the bottom of the discharge chamber 15, resulting in a stronger induced electric field in the near-axis region than in the far-axis region of the discharge chamber 15. In this way, a non-uniform distribution of plasma with more plasma in the near-axis region and less plasma in the far-axis region of the discharge chamber 15 is achieved. In addition, through adjusting the capacitance of the second adjustable capacitor VC2 and the capacitance of the third adjustable capacitor VC3, the power distribution between the surface coil 13 and the cylindrical coil 14 is adjusted, achieving refined uniformity adjustment.

According to a fifth configuration, reference is made to FIG. 10, which is a schematic diagram of an arrangement of a surface coil and a cylindrical coil on a discharge chamber according to another embodiment of the present disclosure. As shown in FIG. 10, the cylindrical coil 14 is wound on the outer sidewall of the discharge chamber 15 a centrosymmetric manner, and the surface coil 13 is arranged in a centrosymmetric manner in an edge region of the bottom of the discharge chamber 15, resulting in a stronger induced electric field in the far-axis region than in the near-axis region of the discharge chamber 15. In this way, a non-uniform distribution of plasma with less plasma in the near-axis region and more plasma in the far-axis region of the discharge chamber 15 is achieved. In addition, through adjusting the capacitance of the second adjustable capacitor VC2 and the capacitance of the third adjustable capacitor VC3, the power distribution between the surface coil 13 and the cylindrical coil 14 is adjusted, achieving refined uniformity adjustment.

It can be seen from the above descriptions that, based on different arrangement combination configurations of the surface coil 13 and the cylindrical coil 14, a desired plasma density distribution can be achieved, thereby achieving the uniformity adjustment in etching.

In another embodiment of the present disclosure, as shown in FIG. 3, the uniformity adjustment apparatus further includes an optical grid system.

The optical grid system is configured to extract the plasma generated in the discharge chamber 15.

The optical grid system includes a grid 16, a first power supply Beam-V, a second power supply Accelerate-V, a first filter, and a second filter.

The grid 16 is arranged at an outlet of the discharge chamber 15, the grid 16 includes a screen grid and an acceleration grid, and the screen grid is arranged between the acceleration grid and the outlet of the discharge chamber 15.

The first power supply Beam-V is connected to the screen grid. In an embodiment, the first power supply Beam-V is connected to the screen grid through the first filter.

The second power supply Accelerate-V is connected to the acceleration grid. In an embodiment, the second power supply Accelerate-V is connected to the acceleration grid through the second filter.

The first filter includes a fourth capacitor C4 and a second induction coil L2.

A first terminal of the fourth capacitor C4 is connected to a first terminal of the second induction coil L2 at a connection node, and the connection node is connected to an output terminal of the first power supply Beam-V.

A second terminal of the second induction coil L2 is connected to the screen grid.

A second terminal of the fourth capacitor C4 is grounded.

The second filter includes a fifth capacitor C5 and a third induction coil L3.

A first terminal of the fifth capacitor C5 is connected to a first terminal of the third induction coil L3 at a connection node, and the connection node is connected to an output terminal of the second power supply Accelerate-V.

A second terminal of the third induction coil L3 is connected to the acceleration grid.

A second terminal of the fifth capacitor C5 is grounded.

In an embodiment, the optical grid system according to the embodiments of the present disclosure is configured to extract ions as ion beams. It can be seen from the above descriptions that, in the uniformity adjustment apparatus for ion beam etching, the power of the surface coil 13 and/or the power of the cylindrical coil 14 in the uniformity adjustment coil component arranged at a pre-determined position of the discharge chamber 15 is adjusted through the uniformity adjustment capacitor component 12, so as to adjust the plasma density distribution in the discharge chamber 15. In addition, the configurations of the arrangement of the surface coil 13 and/or the cylindrical coil 14 may be further optimized (for example, the surface coil 13 and/or the cylindrical coil 14 is arranged in a non-centrosymmetric manner or a centrosymmetric manner) to further precisely adjust the plasma density distribution in the discharge chamber 15, so that a desired plasma density distribution in the discharge chamber 15 is achieved. The plasma is then extracted from the optical grid system, thereby realizing uniformity adjustment in ion beam etching, especially in etching of a slanted grating.

It should be noted that the full name of FT in FIG. 3 is Feed Through. An FT is a sealed connector, that is, the discharge chamber 15 is arranged in a vacuum environment. The radio frequency power supply RF1, the power supply matching network 11, the uniformity adjustment capacitor component 12, the uniformity adjustment coil component, the second capacitor C2, the third capacitor C3, the first power supply Beam-V, the second power supply Accelerate-V, the first filter and the second filter are arranged in an atmospheric environment. The connection between the component in the vacuum environment and the component in the atmospheric environment is implemented by the sealed connector FT.

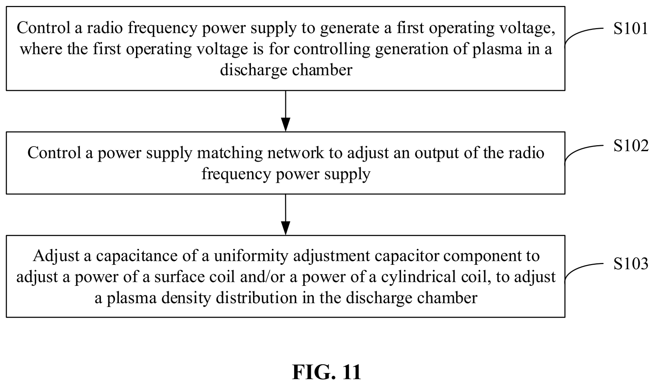

Based on all the above embodiments in the present disclosure, in another embodiment of the present disclosure, a uniformity adjustment method for ion beam etching is further provided. The uniformity adjustment method is implemented based on the uniformity adjustment apparatus described in any one of the above embodiments. Reference is made to FIG. 11, which is a flowchart of a uniformity adjustment method for ion beam etching according to an embodiment of the present disclosure. The uniformity adjustment method includes step S101 to S103.

In step S101, the radio frequency power supply is controlled to generate the first operating voltage. The first operating voltage is for controlling generation of plasma in the discharge chamber.

In step S102, the power supply matching network is controlled to adjust the output of the radio frequency power supply.

In step S103, the capacitance of the uniformity adjustment capacitor component is adjusted to adjust the power of the surface coil and/or the power of the cylindrical coil, to adjust a plasma density distribution in the discharge chamber.

In another embodiment of the present disclosure, the uniformity adjustment capacitor component includes a second adjustable capacitor and a third adjustable capacitor.

A first terminal of the second adjustable capacitor is connected to a first terminal of the third adjustable capacitor at a connection node, and the connection node is connected to an output terminal of the power supply matching network. A second terminal of the second adjustable capacitor is configured as a first output terminal of the uniformity adjustment capacitor component. A second terminal of the third adjustable capacitor is configured as the second output terminal of the uniformity adjustment capacitor component.

The adjusting the capacitance of the uniformity adjustment capacitor component to adjust the power of the surface coil and/or the power of the cylindrical coil, to adjust the plasma density distribution in the discharge chamber includes: adjusting a capacitance of the second adjustable capacitor and/or a capacitance of the third adjustable capacitor to adjust the power of the surface coil and/or the power of the cylindrical coil, to adjust the plasma density distribution in the discharge chamber.

In another embodiment of the present disclosure, the capacitance of the second adjustable capacitor ranges from OpF to 250pF. The capacitance of the third adjustable capacitor ranges from OpF to 250pF.

It should be noted that the uniformity adjustment method for ion beam etching according to the embodiments of the present disclosure embodiment follows the sample principle as the uniformity adjustment apparatus for ion beam etching according to the above described embodiments of the present disclosure, and the principle is not repeated herein.

Hereinabove the apparatus and method for uniformity adjustment in ion beam etching according to the present disclosure are described in detail. Principles and implementations of the present disclosure are described by using specific embodiments. The description of the above embodiments is merely intended to help understand the method and the key concepts of the present disclosure. In addition, those skilled in the art can make variations in the specific implementation and the scope of application according to the concepts of the present disclosure. In summary, the content of this specification should not be understood as limitations on the present disclosure.

It should be noted that the embodiments in this specification are described in a progressive way, each of the embodiments emphasizes the differences from other embodiments, and the same or similar parts among the embodiments may be referred to each other. Since the device disclosed in the embodiments corresponds to the method disclosed in the embodiments, the description for the device is simple, and reference may be made to the method in the embodiments for the relevant parts.

It should be noted that the relationship terms "first", "second" and the like are only used herein to distinguish one entity or operation from another, rather than to necessitate or imply that an actual relationship or order exists between the entities or operations. Furthermore, terms of "include", "comprise" or any other variants are intended to be non-exclusive. Therefore, a process, method, article or device including a series of elements includes not only the listed elements but also elements inherent in the process, method, article or device. Unless expressively limited, the statement "including a..." does not exclude the case that other similar elements may exist in the process, method, article or device other than enumerated elements.

The description of the embodiments herein enables those skilled in the art to implement or use the present disclosure. Various modifications to these embodiments are apparent for those skilled in the art, and the generic principles defined herein may be implemented in other embodiments without departing from the spirit or scope of the present disclosure. Hence, the present disclosure is not limited to the embodiments disclosed herein, but shall conform to the widest scope in accordance with the principle and novel features disclosed herein.

## Claims

1. A uniformity adjustment apparatus for ion beam etching, wherein the uniformity adjustment apparatus comprises a radio frequency power supply, a power supply matching network, a uniformity adjustment capacitor component, a uniformity adjustment coil component and a discharge chamber, wherein
the uniformity adjustment coil component comprises a surface coil and a cylindrical coil, wherein a first terminal of the cylindrical coil is connected to a first output terminal of the uniformity adjustment capacitor component, and a first terminal of the surface coil is connected to a second output terminal of the uniformity adjustment capacitor component, and wherein the surface coil is arranged at a bottom of the discharge chamber and the cylindrical coil is wound on an outer sidewall of the discharge chamber;
the radio frequency power supply is configured to generate a first operating voltage for controlling generation of plasma in the discharge chamber;
the power supply matching network is configured to adjust an output of the radio frequency power supply; and
the uniformity adjustment capacitor component configured to adjust a power of the surface coil and/or a power of the cylindrical coil through adjusting a capacitance of the uniformity adjustment capacitor component, to adjust a plasma density distribution in the discharge chamber.

2. The uniformity adjustment apparatus according to claim 1, wherein the power supply matching network comprises: a first adjustable capacitor, a first induction coil and a first capacitor;
a first terminal of the first induction coil is connected to a first terminal of the first adjustable capacitor at a connection node, and the connection node is connected to an output terminal of the radio frequency power supply;
a second terminal of the first adjustable capacitor is grounded; and
a second terminal of the first induction coil is connected to a first terminal of the first capacitor, and a second terminal of the first capacitor is configured as an output terminal of the power supply matching network.

3. The uniformity adjustment apparatus according to claim 1, wherein the uniformity adjustment capacitor component comprises a second adjustable capacitor and a third adjustable capacitor;
a first terminal of the second adjustable capacitor is connected to a first terminal of the third adjustable capacitor at a connection node, and the connection node is connected to an output terminal of the power supply matching network;
a second terminal of the second adjustable capacitor is configured as a first output terminal of the uniformity adjustment capacitor component; and
a second terminal of the third adjustable capacitor is configured as a second output terminal of the uniformity adjustment capacitor component.

4. The uniformity adjustment apparatus according to claim 3, wherein a capacitance of the second adjustable capacitor ranges from 0pF to 250pF.

5. The uniformity adjustment apparatus according to claim 3, wherein a capacitance of the third adjustable capacitor ranges from OpF to 250pF.

6. The uniformity adjustment apparatus according to claim 1, wherein the uniformity adjustment apparatus further comprises a second capacitor and a third capacitor;
a second terminal of the surface coil is grounded through the second capacitor; and
a second terminal of the cylindrical coil is grounded through the third capacitor.

7. The uniformity adjustment apparatus according to claim 1, wherein the surface coil is arranged in a non-centrosymmetric manner at the bottom of the discharge chamber.

8. The uniformity adjustment apparatus according to claim 1, wherein the surface coil is arranged in a centrosymmetric manner at the bottom of the discharge chamber.

9. The uniformity adjustment apparatus according to claim 1, wherein the cylindrical coil is arranged in a non-centrosymmetric manner on the outer sidewall of the discharge chamber.

10. The uniformity adjustment apparatus according to claim 1, wherein the cylindrical coil is arranged in a centrosymmetric manner on the outer sidewall of the discharge chamber.

11. The uniformity adjustment apparatus according to claim 1, wherein the uniformity adjustment apparatus further comprises an optical grid system; and
the optical grid system is configured to extract the plasma generated in the discharge chamber.

12. The uniformity adjustment apparatus according to claim 11, wherein the optical grid system comprises: a grid, a first power supply and a second power supply,
the grid is arranged at an outlet of the discharge chamber, the grid comprises a screen grid and an acceleration grid, and the screen grid is arranged between the acceleration grid and the outlet of the discharge chamber;
the first power supply is connected to the screen grid; and
the second power supply is connected to the acceleration grid.

13. The uniformity adjustment apparatus according to claim 12, wherein the optical grid system further comprises a first filter and a second filter;
the first power supply is connected to the screen grid through the first filter; and
the second power supply is connected to the acceleration grid through the second filter.

14. The uniformity adjustment apparatus according to claim 13, wherein the first filter comprises a fourth capacitor and a second induction coil;
a first terminal of the fourth capacitor is connected to a first terminal of the second induction coil at a connection node, and the connection node is connected to an output terminal of the first power supply;
a second terminal of the second induction coil is connected to the screen grid; and
a second terminal of the fourth capacitor is grounded.

15. The uniformity adjustment apparatus according to claim 13, wherein the second filter comprises a fifth capacitor and a third induction coil;
a first terminal of the fifth capacitor is connected to a first terminal of the third induction coil at a connection node, and the connection node is connected to an output terminal of the second power supply;
a second terminal of the third induction coil is connected to the acceleration grid; and
a second terminal of the fifth capacitor is grounded.

16. A uniformity adjustment method for ion beam etching, wherein the uniformity adjustment method is applied to the uniformity adjustment apparatus according to any one of claims 1 to 15, and the uniformity adjustment method comprises:
controlling the radio frequency power supply to generate the first operating voltage, wherein the first operating voltage is configured to control the generation of plasma in the discharge chamber;
controlling the power supply matching network to adjust the output of the radio frequency power supply; and
adjusting the capacitance of the uniformity adjustment capacitor component to adjust the power of the surface coil and/or the power of the cylindrical coil, to adjust the plasma density distribution in the discharge chamber.

17. The uniformity adjustment method according to claim 16, wherein the uniformity adjustment capacitor component comprises a second adjustable capacitor and a third adjustable capacitor;
a first terminal of the second adjustable capacitor is connected to a first terminal of the third adjustable capacitor at a connection node, and the connection node is connected to an output terminal of the power supply matching network; a second terminal of the second adjustable capacitor is configured as a first output terminal of the uniformity adjustment capacitor component; and a second terminal of the third adjustable capacitor is configured as a second output terminal of the uniformity adjustment capacitor component; and
the adjusting the capacitance of the uniformity adjustment capacitor component to adjust the power of the surface coil and/or the power of the cylindrical coil, to adjust the plasma density distribution in the discharge chamber comprises:
adjusting a capacitance of the second adjustable capacitor and/or a capacitance of the third adjustable capacitor to adjust the power of the surface coil and/or the power of the cylindrical coil, to adjust the plasma density distribution in the discharge chamber.
